# FASCICULE DE BREVET EUROPEEN

(11) **EP 0 546 889 B1**
(45) Date de publication et mention de la délivrance du brevet: **31.05.1995**
(21) Numéro de dépôt: 92403240.2
(22) Date de dépôt: 01.12.1992
(51) Int. Cl.: H01S 3/025, H01L 27/15, H01S 3/25

(54) **Système d'alimentation électrique d'un circuit intégré de lasers semiconducteurs**
Stromzuführungssystem für eine integrierte Halbleiterlaser-Schaltung
Power supply system for an integrated semiconductor laser circuit

(30) Priorité: 10.12.1991 FR 9115269
(43) Date de publication de la demande: 16.06.1993
(73) Titulaire: THOMSON-CSF SEMICONDUCTEURS SPECIFIQUES, 92800 Puteaux (FR)
(72) Inventeur: Groussin, Bernard, Thomson-CSF, F-92402 Courbevoie Cédex (FR)
(74) Mandataire: Guérin, Michel

(56) Documents cités:
- EP-A- 0 369 856
- US-A- 4 881 237
- APPLIED PHYSICS LETTERS. vol. 59, no. 6, 5 Août 1991, New York,US;pages 632 -634,W.D. GOODHUE et al.:"Monolthic two-dimensional surface-emitting strained-layer InGaAs/AlGaAs and AlInGaAs/AlGaAs diode laser arrays with over 50% differential quantum efficiencies"

## Description

La présente invention concerne le domaine des circuits intégrés de lasers semiconducteurs, dans lesquels les barrettes de lasers alternent avec des réglettes de réflecteurs qui dévient les rayons lasers à angle droit jar rapport au plan de circuit intégré. Plus précisément, l'invention concerne le système de distribution de l'alimentation électrique aux lasers d'une barrette.

L'invention concerne également le procédé de réalisation du système de distribution électrique d'un circuit intégré de lasers.

Les circuits intégrés de lasers semiconducteurs sont connus, par exemple du brevet français FR-A- 2 639 150 du 15 novembre 1988, dont la figure 1 ci-jointe reprend une vue de trois-quart dans l'espace, en conservant les mêmes indices de repères.

Un circuit intégré de lasers comporte un substrat 27 en matériaux de la famille III-V : pour simplifier l'exposé, on admettra que le substrat est en GaAs semi-isolant. Dans ce substrat 27 sont taillés des réflecteurs 28, qui se présentent comme des réglettes parallèles entre elles, de section trapézoïdale, avec des côtés inclinés à 45°, ou de section semi-circulaire. Au moins les flancs 29 de ces réglettes sont métallisés, à la fois pour en faire des miroirs plans inclinés à 45° ou semi-cylindriques, et pour conduire le courant.

Entre les réglettes réflectrices sont disposées les barrettes 30 de lasers semiconducteurs. Chaque barrette comprend, réalisées par une suite d'épitaxies, une pluralité de couches de matériaux semiconducteurs, repérées en 16. Dans ces couches sont gravés par usinage ionique une pluralité de sillons 17, parallèles entre eux mais perpendiculaires à l'axe longitudinal de chaque barrette 30 : pris deux par deux, ces sillons 17 définissent les rubans émetteurs 18 de chaque laser élémentaire.

De la série de couches épitaxiées 16, au moins la première couche déposée 40, dopée donc conductrice, recouvre le substrat semi-isolant 27, sur sa surface libre 31 et sur les flancs 29 des réglettes 28 de réflecteurs.

Une métallisation 32 court sur la face supérieure, libre, de chaque barrette de lasers 30, et une métallisation 33 court sur la face supérieure de chaque réglette 28 de réflecteurs : ces deux métallisations 32 et 33 permettent, en liaison avec la couche conductrice épitaxiée 40, d'alimenter en courant les lasers élémentaires.

Lorsque le circuit intégré est mis sous tension, chaque laser élémentaire émet par son ruban 18 un faisceau de lumière cohérente 35 par une face clivée et un faisceau 36 par l'autre face clivée. Ces deux faisceaux sont réfléchis sensiblement perpendiculairement au plan général du circuit intégré par les flancs métallisés 29 des réglettes 28 de réflecteurs. L'ensemble du circuit intégré émet donc une pluralité de faisceaux 35-36, parallèles entre eux et perpendiculaires au plan du substrat.

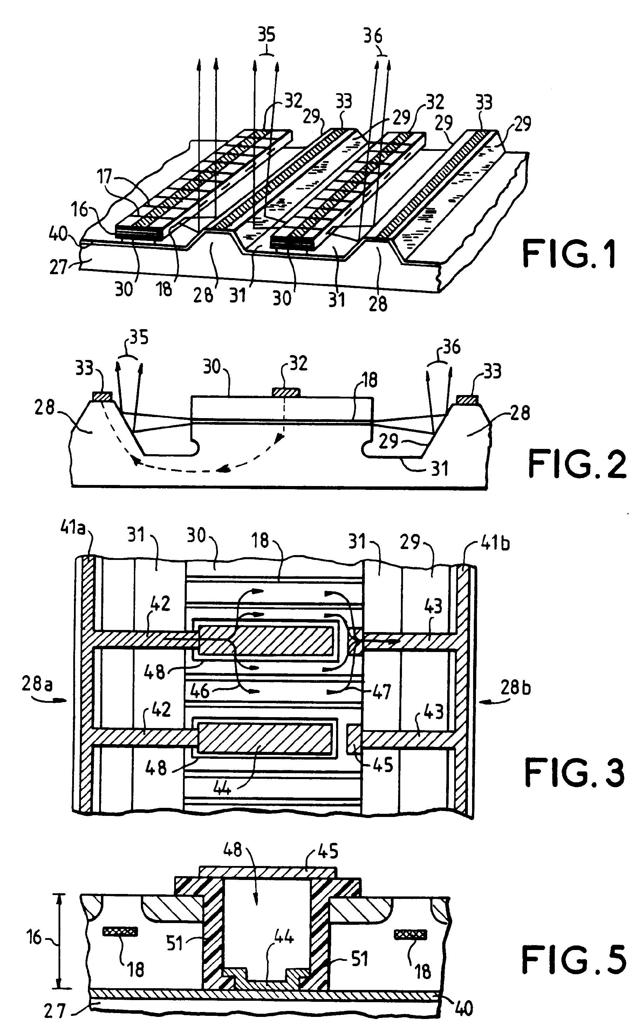

La figure 2 est une vue en coupe d'une région du circuit intégré de la figure 1. Dédiée à l'alimentation électrique d'une barrette de lasers, elle est réduite au seul contour d'une barrette 30 et de deux réglettes de réflecteurs 28, car le détail des couches le matériaux n'apporte rien à l'énoncé du problème d'alimentation électrique.

Un ruban émetteur de laser 18 est alimenté verticalement et le courant passe depuis la métallisation 32 à travers les couches épitaxiées 16 et est évacué par la couche conductrice 40, en surface libre 31 du substrat et en surface des miroirs 29, vers la métallisation 33.Le parcours du courant peut également être inversé, selon le sens des polarités.

Mais si l'on considère la distribution du courant d'alimentation le long d'une barrette de lasers 30, on voit que les métallisations 32 sont parallèles à l'axe longitudinal des barrettes 30, ce qui revient à dire qu'elles sont perpendiculaires aux axes des rubans émetteurs 18. Si les lasers sont, selon la théorie, alimentés en parallèle, donc tous dans les mêmes conditions, la pratique montre que ceux qui sont les plus éloignés de la ou des bornes d'alimentation émettent moins de lumière, parce qu'ils sont moins alimentés. Quelle que soit l'impédance de la source, la finesse de la métallisation 32 lui communique une résistance élevée, et l'échelle de la microélectronique ne permet pas de diminuer cette résistance en jouant sur la largeur et l'épaisseur de la métallisation 32. Il s'ensuit des inégalités dans l'alimentation des quelques 10 à 30 lasers d'une barrette.

L'invention se propose d'améliorer la distribution et l'alimentation électrique des lasers d'une barrette dans un circuit intégré de lasers du type de celui qui a été décrit dans le brevet cité précédemment. Selon l'invention, la distribution du courant électrique s'opère à partir d'un premier peigne de métallisations dont les doigts de peigne sont perpendiculaires à l'axe longitudinal d'une barrette de lasers, donc parallèles aux rubans émetteurs. Un second peigne de métallisations, de même orientation générale, évacue le courant. Pour que chaque laser élémentaire soit traversé verticalement par un courant, l'un des deux peignes de métallisations est enterré ses doigts se terminent dans des fosses creusées dans les couches épitaxiées d'une barrette.

De façon plus précise, l'invention concerne un système d'alimentation électrique d'un circuit intégré de lasers semiconducteurs, comportant un substrat recouvert par une couche dopée conductrice et au moins une barrette de lasers déposée sur le substrat et comprise entre deux réglettes de réflecteurs, taillées dans le même substrat, qui sont perpendiculaires aux axes des rubans émetteurs des lasers de la dite barrette, ce système étant caractérisé en ce que :
a) - l'alimentation électrique des lasers se fait entre deux peignes de métallisations situés de part et d'autre de la barrette et déposés sur les réglettes de réflecteurs, les dents d'au moins un premier peigne étant interdigitées avec les rubans émetteurs de lasers et étant terminées, chacune par une métallisation parallèle à l'axe des dits rubans émetteurs,
b) - pour chaque dent du premier peigne, la métallisation terminale est située au fond d'une fosse gravée dans l'épaisseur des couches semiconductrices de la dite barrette et en contact avec la couche dopée conductrice épitaxiée sur le substrat de la barrette,
c) - pour chaque dent du second peigne, la métallisation terminale est située sur la face supérieure de la barrette de lasers,
d) - les flancs verticaux de chaque fosse et les flancs verticaux des faces longitudinales de la barrette sont recouverts d'une couche d'un matériau diélectrique tel que l'alumine, sur laquelle sont déposées de métallisations verticales, en vue d'assurer la continuité électrique entre les dents des deux peignes d'alimentation et leurs parties terminales situées à des niveaux différents.

L'invention sera mieux comprise par la description qui en est faite maintenant, en regard des figures jointes en annexe, qui représentent :
- figure 1 : vue de trois-quart d'un circuit intégré de lasers, connu, du type auquel est appliquée l'invention,
- figure 2 : schéma en coupe de l'alimentation d'un circuit intégré de lasers, connu,
- figure 3 : schéma en plan de la distribution de l'alimentation électrique entre les lasers d'une barrette dans un circuit intégré de lasers, selon l'invention,
- figure 4 : vue de trois-quart d'un élément de circuit intégré de lasers, modifié pour recevoir le système de distribution électrique selon l'invention,
- figure 5 : vue en coupe d'une fosse d'alimentation électrique selon l'invention.

L'invention s'applique à un circuit intégré de lasers tel que celui décrit précédemment, en s'appuyant sur les figures 1 et 2. Mais, en vue d'améliorer la distribution du courant électrique entre les lasers d'une même barrette, les métallisations sont modifiées, ce qui amène par ailleurs à creuser des fosses dans les couches épitaxiées, entre les rubans émetteurs.

La figure 3 représente une vue en plan d'une fraction de système de distribution du courant sur une barrette. Cette figure est à la même échelle et située en regard de la figure 2, pour faciliter la comparaison. En outre, les indices de repère communs avec l'art antérieur sont conservés, puisqu'ils désignent les mêmes objets.

Ce système de distribution utilise une première réglette 28a de miroir comme bus de distribution du courant et une seconde réglette 28b de miroir comme bus de collection du courant. Les deux réglettes, et donc les deux bus, sont parallèles à l'axe longitudinal de la barrette 30 qu'ils encadrent. Les deux réglettes, s'il n'y a qu'une seule barrette de lasers, ou les deux réglettes extrêmes s'il s'agit d'un circuit intégré de plusieurs barrettes, comportent des bus conducteurs 41 capables de débiter de forts courants sans présenter de résistance élevée comme les métallisations 33 de l'art connu.

A partir d'un premier bus 41a, une première pluralité de dents ou doigts de peignes conducteurs 42 courent sur les faces des miroirs 29 et sur les surfaces libres 31, perpendiculairement à l'axe longitudinal d'une barrette de lasers 30, et par conséquent parallèlement aux rubans émetteurs 18. Les doigts, conducteurs 42 de ce peigne d'alimentation pénètrent entre les lasers élémentaires, et sont répartis parmi la pluralité des lasers l'une même barrette de telle façon que le courant d'alimentation soit réparti régulièrement entre tous les lasers d'une même barrette.

A partir d'un second bus 41b, porté par une réglette 28b, une seconde pluralité de doigts de peignes conducteurs 43 constitue le peigne collecteur de courant. Les premier et second peignes, d'alimentation et collecteur respectivement, se font face de part et d'autre d'une même barrette de lasers, et les dents de peignes 42 et 43 sont sensiblement alignées.

Au niveau d'une barrette de lasers 30, une dent 42 du peigne de distribution se termine par une métallisation 44, et une dent 43 du peigne collecteur se termine par une métallisation 45. Le courant électrique d'alimentation est donc réparti en une pluralité de trajectoires issues du premier peigne et collectées par le second peigne, parallèles aux rubans lasers 18, et illustrées sur la figure 3 par deux jeux de flêches 46 et 47.

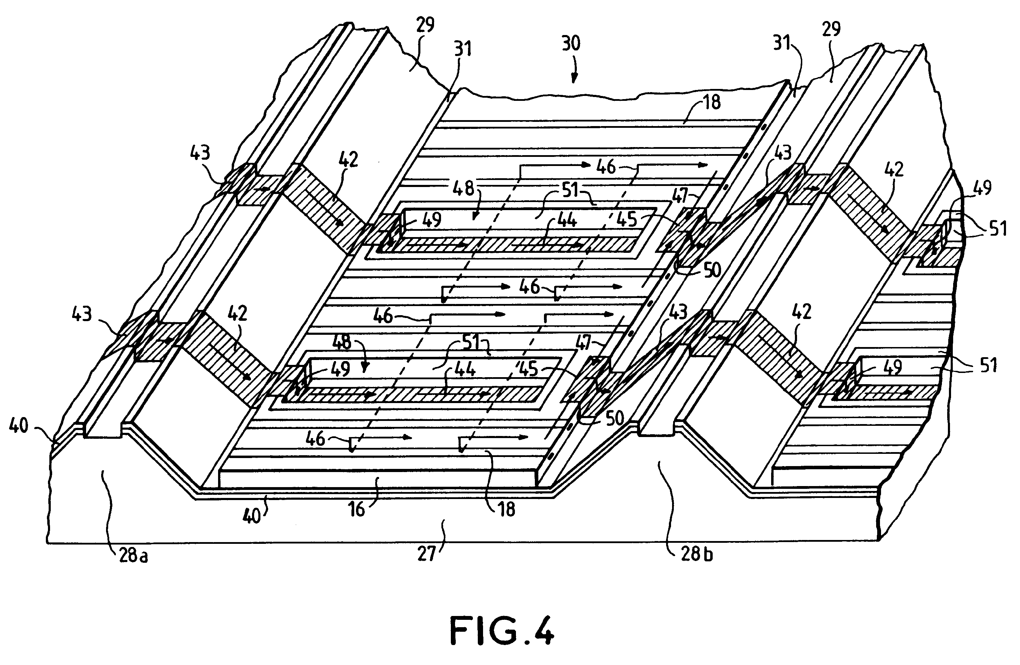

Le parcours du courant à travers les couches semiconductrices 16 d'une barrette 30 est représenté sur la figure 4, qui est une vue dans l'espace d'une région de circuit intégré selon l'invention.

Pour qu'un laser fonctionne, et émet.te un faisceau lumineux, il faut qu'un courant traverse verticalement les différentes couches semiconductrices qui le constituent. Etant donné que les métallisations 42 et 43+45 qui véhiculent ce courant sont en surface du corps du circuit intégré, chaque métallisation 44, en bout de doigt de peigne 42, est déposée dans le fond d'une fosse 48 gravée à travers les couches 16, jusqu'à atteindre la couche dopée 40, conductrice. La figure 5 montre une coupe d'une fosse 48. Sur une même barrette de lasers 30, plusieurs fosses sont gravées parallèlement aux lasers 18, et réparties de telle façon qu'une fosse 48, ou plus précisément la métallisation 44 qui est déposée dans le fond, alimente plusieurs lasers de part et d'autre d'une fosse, par diffusion à travers la couche conductrice 40. C'est ce que représentent les flèches 46, qui s'écartent d'abord des métallisations 44. Puis le courant traverse verticalement les couches 16, parce que les métallisations 45 des collecteurs sont déposées sur le dessus de l'empilement de couches 16.

La continuité électrique entre une métallisation 42, dans sa partie en surface des couches 16, et une métallisation 44, au fond d'une fosse 48, nécessite une métallisation 49 verticale, sur un flanc de fosse. De même, entre une métallisation 45, sur une barrette 30, et une métallisation 43, sur une surface libre 31, se trouve une métallisation 50 verticale à flanc de barrette. Ces deux métallisations 49 et 50 court-circuiteraient les couches semiconductrices 16 si elles n'en étaient pas isolées. A cette fin, une couche 51 d'un isolant tel que l'alumine Al₂O₃ est déposée au moins sur les flancs intérieurs des fosses 48 et sur les flancs des barrettes 30, sous les métallisations 49 et 50.

En outre, la couche d'alumine 51 déposée sur les flancs de fosses qui sont parallèles aux rubans lasers 18 empêche une diffusion latérale de lumière.

La réalisation d'un circuit intégré selon l'invention n'entraîne que peu de modification par rapport au procédé décrit dans le brevet n° 88 14799 cité plus haut. Après gravure du substrat 27 pour obtenir les réglettes 28 de réflecteurs, et croissance épitaxiale des couches 16, les fosses 48 sont gravées avant la réalisation des rubans émetteurs 18.

Les métallisations telles que 45 en surface des barrettes de lasers 30 sont d'abord déposées; elles sont de type p+ en Au-Pt, ou Au-Cr, ou Au-Pt-Ti. Puis les fosses 48 sont creusées par gravure ionique, jusqu'à atteindre la couche conductrice 40, préférentiellement en GaAs. Sur les flancs verticaux des fosses 48 est déposée une couche de diélectrique 51 tel que l'alumine, pour isoler les couches semiconductrices 16 des futures métallisations verticales 49. Bien entendu le procédé de dépôt de diélectrique nécessite de graver la couche qui s'est également déposée sur la barrette 30 et dans le fond des fosses 48 sur la couche conductrice 40.

Sur cette couche 40, ainsi dégagée, sont déposées les métallisations de type n telles que 44 et 49, également obtenues par gravure d'une couche métallique qui s'est déposée sur toutes les surfaces. Les métallisations de type n sont composées de Au-Ge ou Au-Ge-Ni, et Mo et Au.

Ensuite, le procédé de fabrication redevient celui qui a été décrit dans le brevet cité, et se poursuit par la réalisation par implantation des rubans émetteurs 18, la gravure de la structure de barrette qui permet le clivage des faces de lasers et le dépôt des métallisations d'alimentation 42 et 43.

L'invention a été décrite en s'appuyant sur une barrette de lasers 30 : dans un circuit intégré comportant plusieurs barrettes, celles-ci sont alimentées soit en série, soit en parallèles.

## Revendications

1. Système d'alimentation électrique d'un circuit intégré de lasers semiconducteurs, comportant un substrat (27) recouvert par une couche dopée conductrice (40) et au moins une barrette de lasers (30) déposée sur la substrat (27) et comprise entre deux réglettes de réflecteurs (28), taillées dans le même substrat (27), qui sont perpendiculaires aux axes des rubans émetteurs des lasers (18) de la dite barrette (30), ce système étant caractérisé ce que :
a) - l'alimentation électrique des lasers se fait entre deux peignes de métallisations (42,43) situés de part et d'autre de la barrette (30) et déposés sur les réglettes de réflecteurs (28), les dents d'au moins un premier peigne étant interdigitées avec les rubans émetteurs de lasers (18) et étant terminées, chacune, par une métallisation (44) parallèle à l'axe desdits rubans émetteurs (18),
b) - pour chaque dent (42) du premier peigne, la métallisation terminale (44) est située au fond d'une fosse (48) gravée dans l'épaisseur des couches semiconductrices (16) de la dite barrette (30) et en contact avec la couche dopée conductrice (40) épitaxiée sur le substrat (27) de la barrette,
c) - pour chaque dent (43) du second peigne, la métallisation terminale (45) est située sur la face supérieure de la barrette de lasers (30),
d) - les flancs verticaux de chaque fosse (48) et les flancs verticaux des faces longitudinales de la barrette (30) sont recouverts d'une couche (51) d'un matériau diélectrique tel que l'alumine, sur laquelle sont déposées des métallisations verticales (49,50) en vue d'assurer la continuité électrique entre les dents (42,43) des deux peignes d'alimentation et leurs parties terminales (44,45), situées à des niveaux différents.

2. Système d'alimentation selon la revendication 1, caractérisé en ce que chacun des lasers (18) d'une barrette est alimenté verticalement, le courant fourni par le premier peigne étant injecté dans le ruban émetteur à partir de la couche conductrice (40) en contact avec le substrat (27), et étant collecté en surface de la barrette par le second peigne.

## Patentansprüche

1. Stromzuführungssystem für eine integrierte Halbleiterlaser-Schaltung, mit einem von einer leitend dotierten Schicht (40) bedeckten Substrat (27) und wenigstens einem Lasersteg (30), der auf das Substrat (27) aufgebracht und zwischen zwei in das gleiche Substrat (27) eingebrachten Reflektorleisten (28) enthalten ist, die zu den Achsen der Lasersendestreifen (18) des Steges (30) senkrecht sind, wobei dieses System dadurch gekennzeichnet ist, daß
a) - die Stromzuführung für die Laser zwischen zwei Metallisierungskämmen (42, 43) erfolgt, die beiderseits des Steges (30) angeordnet und auf die Reflektorleisten (28) aufgebracht sind, wobei die Zähne wenigstens eines ersten Kammes mit den Lasersendestreifen (18) verschachtelt sind und jeweils in einer zur Achse der Sendestreifen (18) parallelen Metallisierung (44) enden,
b) - bei jedem Zahn (42) des ersten Kammes die Endmetallisierung (44) am Boden einer in die Dickenabmessung der Halbleiterschichten (16) des Steges (30) eingeätzten Grube (48) angeordnet ist und mit der auf das Substrat (27) des Steges aufgewachsenen leitend dotierten Schicht (40) in Kontakt steht,
c) - bei jedem Zahn (43) des zweiten Kammes die Endmetallisierung (45) auf der Oberseite des Lasersteges (30) angeordnet ist, und
d) - die vertikalen Flanken jeder Grube (48) und die vertikalen Flanken der Längsseiten des Steges (30) von einer Schicht (51) aus einem dielektrischen Material wie etwa Aluminiumoxid bedeckt sind, auf der vertikale Metallisierungen (49, 50) aufgebracht sind, um den Stromfluß zwischen den Zähnen (42, 43) der beiden Zuführungskämme und deren Endteilen (44, 45) sicherzustellen, die auf unterschiedlichen Niveaus angeordnet sind.

2. Zuführungssystem nach Anspruch 1, dadurch gekennzeichnet, daß jeder der Laser (18) eines Steges vertikal gespeist wird, wobei der von dem ersten Kamm gelieferte Strom ausgehend von der mit dem Substrat (27) in Kontakt stehenden Leiterschicht (40) in den Sendestreifen eingeführt und auf der Oberfläche des Steges durch den zweiten Kamm aufgenommen wird.

## Claims

1. Electrical power supply system for an integrated semiconductor laser circuit, including a substrate (27) covered by a conducting doped layer (40) and at least one row of lasers (30) deposited on the substrate (27) and lying between two reflector strips (28), cut into the same substrate (27), which are perpendicular to the axes of the laser emitter ribbons (18) of the said row (30), this system being characterized in that:
a) - the electrical power supply for the lasers is taken between two metallization combs (42, 43) situated on either side of the row (30) and deposited on the reflector strips (28), the teeth of at least one first comb being interdigitated with the laser emitter ribbons (18) and each being terminated by a metallization (44) parallel to the axis of the said emitter ribbons (18),
b) - for each tooth (42) of the first comb, the terminal metallization (44) is situated at the bottom of a recess (48) etched into the thickness of the semiconducting layers (16) of the said row (30) and in contact with the epitaxial conducting doped layer (40) on the substrate (27) of the row,
c) - for each tooth (43) of the second comb, the terminal metallization (45) is situated on the upper face of the row of lasers (30),
d) the vertical flanks of each recess (48) and the vertical flanks of the longitudinal faces of the row (30) are covered by a layer (51) of a dielectric material such as alumina, on which vertical metallizations (49, 50) are deposited for the purpose of ensuring electrical continuity between the teeth (42, 43) of the two power supply combs and their terminal parts (44, 45), situated at different levels.

2. Power supply system according to Claim 1, characterized in that each of the lasers (18) of a row is supplied with power vertically, the current supplied by the first comb being injected into the emitter ribbon from the conducting layer (40) in contact with the substrate (27), and being collected at the surface of the row by the second comb.
